# DEMANDE DE BREVET EUROPEEN

(11) **EP 2 492 847 A1**
(43) Date de publication de la demande: **29.08.2012**
(21) Numéro de dépôt: 11156040.5
(22) Date de dépôt: 25.02.2011
(51) Int. Cl.: G06K 19/077

(54) **Carte incorporant un transpondeur**

(71) Demandeur: NagraID S.A., 2301 La Chaux-de-Fonds (CH)
(72) Inventeur: Droz, François, 2035 Corcelles (CH)
(74) Mandataire: Surmely, Gérard

(57) **Abrégé**

Carte (2) incorporant un transpondeur qui comprend une unité électronique (6) et une antenne (8) reliée électriquement à cette unité électronique, cette antenne étant formée par une piste conductrice non isolée (10) qui est agencée sur un support isolant. La piste conductrice définit au moins une spire (12) et a une première extrémité et une seconde extrémité situées respectivement d'un côté et de l'autre de cette au moins une spire. L'unité électronique est agencée à l'intérieur ou à l'extérieur de cette au moins une spire du côté de ladite première extrémité à laquelle elle est reliée électriquement. La seconde extrémité de ladite piste conductrice est reliée électriquement à l'unité électronique par un fil électrique (30) muni d'une gaine isolante et traversant ladite au moins une spire, les première et seconde parties d'extrémité (32, 34) de ce fil électrique étant au moins partiellement dénudées pour assurer les contacts électriques nécessaires à la liaison électrique entre ladite deuxième extrémité de la piste conductrice et l'unité électronique.

## Description

### Domaine technique

La présente invention concerne le domaine des cartes électroniques comprenant un transpondeur formé d'une unité électronique et d'une antenne présentant au moins une spire. D'autres éléments électroniques peuvent également être incorporés dans de telles cartes. Par carte, on comprend non seulement des cartes plastiques au format bancaire et autres cartes s'étendant dans un plan général principal avec un contour quelconque, mais également des jetons, des tickets, des étiquettes, etc. En particulier, la présente invention concerne des cartes d'accès ou tickets RFID munis d'un transpondeur permettant de les identifier à distance par un lecteur radiofréquence (RF).

### Arrière-plan technologique

On intègre depuis de nombreuses années des transpondeurs dans des cartes électroniques avec des antennes du type bobine. En particulier, l'antenne-bobine est formée par une piste conductrice non isolée (c'est-à-dire dont la face opposée au support isolant n'est pas recouverte d'un film ou d'une laque isolante avant l'établissement des liaisons électriques de l'antenne à l'unité électrique). La piste conductrice est agencée sur un support isolant en définissant quelques spires séparées l'une de l'autre. Cette piste conductrice peut notamment être déposée par une technique d'impression ou être gravée dans une feuille conductrice déposée au préalable sur le support isolant.

Un problème connu de longue date dans la fabrication de cartes électroniques du type décrit ci-avant provient du fait que les deux extrémités de l'antenne-bobine sont respectivement situées d'un côté et de l'autre des spires, ce qui pose un problème pour relier électriquement ces deux extrémités à l'unité électronique. Diverses solutions ont déjà été proposées. Il a notamment été proposé d'agencer l'unité électronique au-dessus des spires mais une telle technique n'est envisageable que dans des cas particuliers avec une unité électronique relativement grande ou une bobine avec peu de spires. La formation de la carte n'est pas évident car il ne faut pas qu'une étape de laminage enfonce l'unité électronique dans le support en sectionnant l'antenne. Ainsi, dans le cadre de la présente invention, il est prévu que l'unité électronique soit agencée à l'intérieur ou à l'extérieur des spires de l'antenne. Dans ce dernier cas, pour résoudre le problème de connexion, on a proposé d'utiliser des vias au travers du support isolant avec le dépôt d'une piste de liaison au dos de ce support. Cette technique est relativement complexe puisqu'il est nécessaire de réaliser des vias et d'agencer des pistes conductrices sur les deux faces opposées du support isolant. Pour pallier cet inconvénient, le document EP 1 168 239 (voir sa figure 2) propose d'agencer en travers des spires de l'antenne imprimée un pont isolant. Ce pont isolant peut être déposé également par une technique d'impression. Ensuite, un tronçon de piste conductrice est imprimée sur le pont isolant pour relier deux plages de contact situées respectivement d'un côté et de l'autre des spires de l'antenne. Cette dernière technique demande plusieurs opérations successives qui augmentent le temps de production et donc le coût des cartes obtenues.

### Résumé de l'invention

Le but de la présente invention est de fournir une carte électronique incorporant un transpondeur qui soit réalisable à moindre coût tout en étant fiable.

A cet effet, la présente invention concerne une carte électronique incorporant un transpondeur qui comprend une unité électronique et une antenne reliée électriquement à cette unité électronique, cette antenne étant formée par une piste conductrice non isolée qui est agencé(e) sur un support isolant, le fil conducteur ou la piste conductrice définissant au moins une spire et ayant une première extrémité et une seconde extrémité situées respectivement d'un côté et de l'autre de cette au moins une spire. L'unité électronique est agencée à l'intérieur ou à l'extérieur de ladite au moins une spire du côté de la première extrémité de la piste conductrice et est reliée électriquement à cette première extrémité. La seconde extrémité de la piste conductrice est reliée électriquement à l'unité électronique par un fil électrique muni d'une gaine isolante et traversant ladite au moins une spire, les première et seconde parties d'extrémité de ce fil électrique étant au moins partiellement dénudées pour assurer les contacts électriques nécessaires à la liaison électrique entre la deuxième extrémité de la piste conductrice et l'unité électronique.

Selon un mode de réalisation préféré, les première et seconde parties d'extrémité du fil électrique présentent respectivement des première et seconde zones aplaties et dénudées définissant deux zones de contact électrique de ce fil électrique.

### Brève description des dessins

La présente invention sera décrite plus en détail dans la description suivante d'un mode de réalisation, de variantes de celui-ci et d'une installation pour l'apport du fil électrique isolé et son agencement sur le support isolant, cette description étant faite en référence aux dessins annexés, donnés à titre d'exemples nullement limitatifs, dans lesquels :
- La Figure 1 est une vue partielle de dessus d'une carte électronique selon l'invention en cours de fabrication ;
- La Figure 2 est une vue partielle en coupe de la carte électronique en cours de fabrication représentée à la Figure 1 ;
- La Figure 3 est une vue partielle en coupe, similaire à celle de la Figure 2, de la carte électronique de la Figure 1 finie ou du corps intermédiaire d'une telle carte électronique ;
- La Figure 4 est une vue partielle de dessus d'une variante de réalisation d'une carte électronique selon l'invention en cours de fabrication ; et
- La Figure 5 montre schématiquement une installation d'apport de tronçons de fil électrique isolé avec leurs deux extrémités dénudées intervenant dans la fabrication de cartes électroniques selon l'invention.

### Description détaillée de l'invention

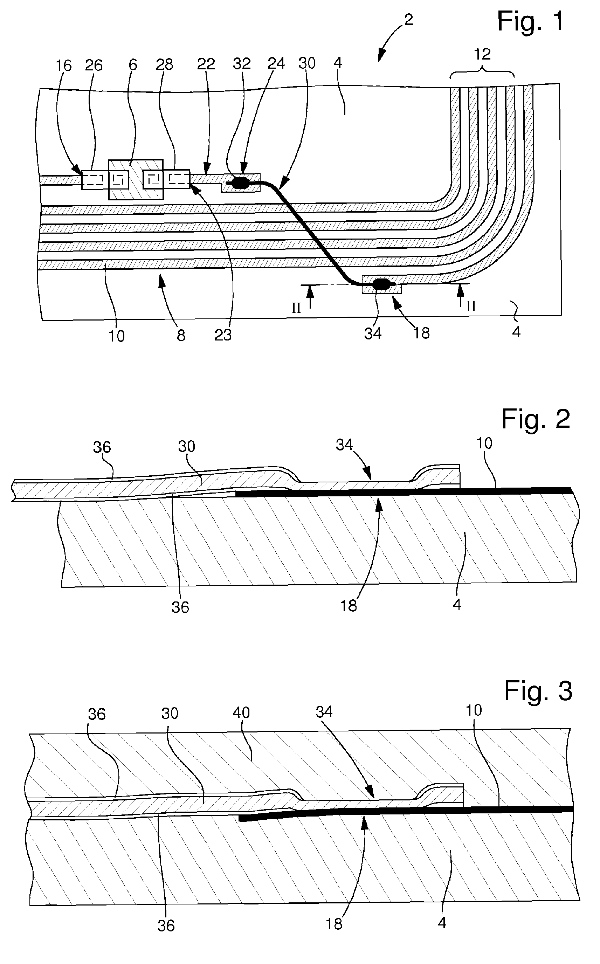

A l'aide des Figures 1 et 2, on décrira ci-après un mode de réalisation d'une carte électronique selon l'invention, cette carte étant montrée partiellement sur ces figures. La carte électronique 2 comprend un transpondeur incorporé dans son corps, c'est-à-dire à l'intérieur de la carte. Ce transpondeur est formé par une unité électronique 6 reliée électriquement à une antenne 8. Cette antenne est formée par une piste conductrice non isolée 10 qui est agencée sur un support isolant 4 et qui définit quelques spires 12 (une variante avec une seule spire est aussi concernée par l'invention). La piste conductrice est par exemple obtenue par l'impression d'une encre conductrice ou par une gravure dans un film métallique déposé sur le support 4. L'antenne présente une première extrémité 16 et une seconde extrémité 18 situées respectivement d'un côté et de l'autre des spires 12. L'unité électronique 6 est agencée à l'intérieur de ces spires du côté de ladite première extrémité 16 à laquelle elle est reliée électriquement par une languette métallique 26. Dans une autre variante, l'unité électronique est située à l'extérieur des spires.

De manière générale, ladite seconde extrémité 18 de la piste conductrice 10 est reliée électriquement à l'unité électronique 6 par un fil électrique 30 muni d'une gaine isolante 36. Ce fil électrique traverse les spires 12 et ses première et seconde parties d'extrémité sont au moins partiellement dénudées pour assurer les contacts électriques nécessaires à la liaison électrique entre la deuxième extrémité 18 de la piste conductrice et l'unité électronique 6. Les zones dénudées sont situées de part et d'autre des spires 12, la partie du fil électrique 30 superposée à ces spires étant isolée par la gaine isolante qui l'entoure. Ainsi, la traversée des spires n'engendre aucun problème de court-circuit. Comme le fil apporté est lui-même isolé, il n'est pas nécessaire de recouvrir au moins localement ces spires par un film isolant de protection comme dans l'art antérieur.

Dans la variante représentée à la Figure 1, un tronçon de piste conductrice supplémentaire 22, définissant des première et seconde plages de contact 23 et 24, est agencé sur le support isolant 4 du côté de l'unité électronique relativement aux spires 12. La première plage de contact 23 est reliée électriquement à l'unité électronique par une languette métallique 28. Les première et seconde parties d'extrémité du fil électrique 30 présentent respectivement des première et seconde zones aplaties et dénudées 32 et 34 définissant deux zones de contact électrique de ce fil électrique. La première zone aplatie et dénudée 32 est superposée à la seconde plage de contact 24 du tronçon de piste conductrice supplémentaire 22 et est reliée électriquement à cette seconde plage. La seconde zone aplatie et dénudée 34 est superposée à la seconde extrémité 18 de ladite piste conductrice 10 formant l'antenne et est reliée électriquement à cette seconde extrémité.

On notera que dans un autre mode de réalisation non représenté dans les figures, la seconde extrémité du fil électrique 30 est directement reliée à une plage de contact de l'unité électronique formée notamment par un plot métallique. On remarquera aussi que les deux extrémités dénudées du fil électrique 30 peuvent ne pas être aplaties. Le laminage permet de déformer les deux plages de contact qui épousent alors le fil circulaire sur une certaine surface de contact. Dans une variante de réalisation, les extrémités du fil électrique sont soudées aux plages de contact correspondantes. Dans ce dernier cas, le l'opération de soudage peut servir conjointement à dénuder les extrémités du fil électrique.

Dans une variante de réalisation avantageuse, le contact électrique entre la première zone aplatie et dénudée 32 du fil électrique et la seconde plage de contact 24 du tronçon de piste conductrice 22 ainsi que le contact électrique entre la seconde zone aplatie et dénudée 34 du fil électrique et la seconde extrémité 18 de la piste conductrice 10 sont réalisés sans soudure. Comme représenté à la Figure 3, un matériau d'enrobage assure l'application de ces zones aplaties et dénudées respectivement contre la seconde plage de contact 24 et contre la seconde extrémité 18 de la piste conductrice. L'enrobage est effectué dans cette variante par le support 4 et une couche supérieure 40 laminées ensemble. Le contact physique assurant la connexion électrique est maintenu par la couche supérieure qui adhère solidement au support 4. On notera que suite à l'étape de laminage, l'interface entre le support 4 et la couche supérieure 40 peut disparaître de sorte qu'elles ne forment qu'une seule et même masse plastique enrobant le transpondeur et formant un corps de la carte. La carte 42 peut définir une carte finie sur laquelle une impression peut éventuellement être prévue dans une étape finale ou définir un 'prélam' ou 'inlet', c'est-à-dire un produit intermédiaire destiné à être terminé par l'apport de couches ou films additionnels sur ses faces.

A la figure 1, l'extrémité 18 de la piste conductrice 10 présente une largeur supérieure à celle de la partie de cette piste conductrice formant les spires 12. Cependant, dans une autre variante, l'extrémité 18 et les spires ont une même largueur.

Le fil électrique 30 avec sa gaine isolante 36 peut avoir un diamètre relativement faible, de préférence un diamètre compris entre 50 et 150 microns (50-150 µm). L'homme de métier n'aurait pas envisagé cette solution avec un fil électrique, en particulier de section sensiblement circulaire, dans une telle carte obtenue par un procédé comprenant un laminage. En effet, a priori, une telle solution paraît techniquement non appropriée car lors de l'étape de laminage on s'attend à ce que le fil électrique 30 sectionne les spires 12. Cependant, notamment avec un fil électrique de petit diamètre, on a constaté que les spires ne sont pas sectionnées sans modifier le procédé de laminage, et ceci même avec une piste conductrice imprimée. Une piste conductrice obtenue par gravure d'un film métallique déposé sur le support 4 est encore plus robuste et supporte sans problème des diamètres de fil électrique plus grand que 150 µm. Par ailleurs, avec un grand diamètre, l'homme du métier peut ajuster les divers paramètres du laminage pour permettre une déformation des spires sous le fil électrique sans qu'il y ait rupture de celles-ci.

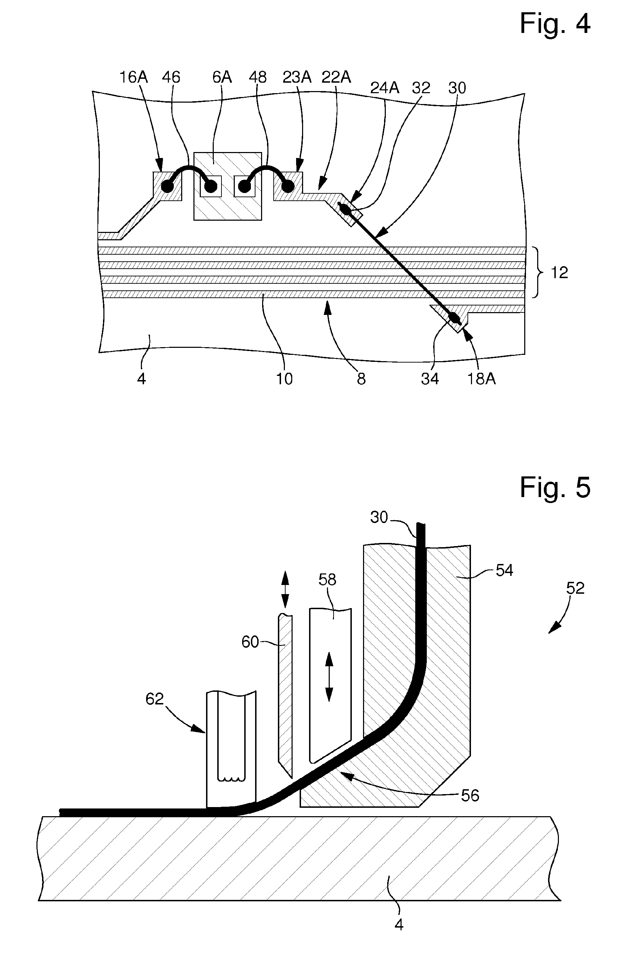

A la Figure 4 est représentée une variante de réalisation de la carte de la Figure 1. Dans la variante de la Figure 1, les parties d'extrémité du fil électrique 30 sont alignées sur la direction des spires 12 dans la région de croisement entre ce fil électrique et ces spires, alors que la partie centrale isolée de ce fil électrique traverse obliquement les spires de l'antenne 8. Ainsi, le fil électrique présente un tracé non rectiligne, ce qui est réalisable sans grande difficulté, mais toutefois à l'aide d'une installation relativement sophistiquée développée dans le cadre de la présente invention et qui sera décrite par la suite à l'aide de la Figure 5. Dans la variante de la Figure 4, l'extrémité 18A de la piste conductrice 10 et la plage de contact 24A du tronçon conducteur 22A sont configurées de manière que les parties d'extrémité, notamment les zones de contact 32 et 34, du fil électrique 30 soient alignées sur la partie centrale de ce fil électrique de sorte qu'il conserve sur toute sa longueur une même direction rectiligne. Sans lien direct avec l'invention, l'unité électronique 6A comprend deux plages de contact reliées aux plages 16A (première extrémité de la piste conductrice) et 23A (première plage de contact du tronçon conducteur supplémentaire) par des fils de soudure 46 et 48 (technologie 'Wire Bonding').

A la Figure 5 est représentée schématiquement une installation 52 d'apport du fil électrique 30 sur le support 4 de la carte en fabrication. Cette installation est adaptée à une fabrication de plusieurs cartes en lot. Le fil électrique 30 nécessaire à chaque carte est de fait un tronçon de fil auquel est donnée la même référence 30. Cette installation permet de produire successivement à haute cadence de tels tronçons de fil électrique isolé avec deux zones aplaties et dénudées (donc sans la gaine isolante 36) respectivement dans les deux parties d'extrémité de chaque tronçon de fil. De plus, cette installation permet de déposer un tronçon selon un tracé non rectiligne comme représenté par exemple à la Figure 1. A cet effet, l'installation 52 comprend une tête avec un canal dans lequel le fil électrique 30 est conduit jusqu'à une partie terminale 56 de cette tête qui présente une surface inclinée définissant une enclume pour un outil de frappe ou poinçon 58 mobile selon une direction verticale et prévu pour réaliser les deux zones de contact de chaque tronçon de fil fabriqué. Cet outil de frappe est suivi par une lame 60 également mobile verticalement et prévue pour sectionner des tronçons du fil électrique 30. Dans une variante, il est prévu un ciseau à la place de la lame mobile pour faciliter et assurer le sectionnement du fil. Finalement, un organe presseur 62 suit la lame et sert à appliquer le fil électrique contre le support 4. Pour faciliter cette opération, l'organe presseur 62 est de préférence muni d'un élément chauffant pour chauffer un peu la gaine 36. On remarquera qu'il est possible de prévoir une inversion de l'outil de frappe et la lame étant donné que l'organe presseur 62 maintient le fil en place. Dans une variante préférée, la gaine 36 est thermocollante de sorte que l'apport de chaleur permet de coller le fil sur le support 4 et sur les spires 12. Dans une autre variante, il est prévu de faire pénétrer un peu le fil électrique dans le support 4 à l'aide de l'organe presseur, avec ou sans apport de chaleur, comme représenté à la Figure 2.

Le fonctionnement de l'installation est la suivante : Le fil électrique isolé 30 est poussé dans le canal de la tête 54 et l'outil de frappe écrase une première fois le fil électrique 30 pour réaliser une première zone aplatie et au moins partiellement dénudée. L'enlèvement localisé de la gaine isolante est obtenu par l'outil de frappe lors de l'écrasement qui varie localement la forme du fil électrique en faisant éclater localement la gaine par déformation de la forme tubulaire de cette gaine et par le fait que le pourtour d'une section circulaire est inférieur au pourtour d'une section rectangulaire de même surface si l'écrasement est significatif. A titre d'exemple, le fil électrique circulaire à un diamètre d'environ 80 µm et la zone aplatie présente une épaisseur d'environ 30 µm. Simultanément ou au moins avant que cette zone aplatie ne dépasse la position de la lame 60, celle-ci est descendue (ou le ciseau est actionné) pour sectionner le fil et former une première partie terminale du tronçon de fil électrique à déposer sur le support 4. Le fil est ensuite poussé dans la tête et la première partie terminale arrive sous l'organe presseur 62 qui l'applique contre le support de manière que la première zone aplatie et dénudée soit superposée à une première plage de contact agencée sur ce support. L'installation 52 est alors déplacée horizontalement en synchronisation avec l'avancement du fil dans le canal de la tête 54, selon un tracé prédéterminé, pour traverser les spires de l'antenne jusqu'à proximité d'une deuxième plage de contact du support. L'outil de frappe est alors à nouveau actionné pour réaliser la seconde zone aplatie et au moins partiellement dénudée qui ensuite est déplacée au-delà de la lame 60 qui alors coupe à nouveau le fil pour définir sa seconde partie terminale. La tête continue d'être déplacée et cette seconde partie terminale arrive sous l'organe presseur qui l'applique contre le support de manière que la seconde zone aplatie et dénudée soit superposée à la deuxième plage de contact du support 4.

Finalement, on notera que l'opération de dénudation des parties terminales du fil électrique 30 peut, dans d'autres modes de mise en oeuvre du procédé de formation du transpondeur sur un support isolant selon l'invention, être réalisée par une thermode appliquée localement à ces parties terminales ou par un chalumeau fournissant une petite flamme permettant de sublimer localement la gaine isolante.

## Revendications

1. Carte incorporant un transpondeur qui comprend une unité électronique (6; 6A) et une antenne (8) reliée électriquement à cette unité électronique, cette antenne étant formée par une piste conductrice non isolée (10) qui est agencée sur un support isolant (4), cette piste conductrice définissant au moins une spire (12) et ayant une première extrémité (16;16A) et une seconde extrémité (18;18A) situées respectivement d'un côté et de l'autre de cette au moins une spire, ladite unité électronique étant agencée à l'intérieur ou à l'extérieur de cette au moins une spire du côté de ladite première extrémité à laquelle elle est reliée électriquement, **caractérisée en ce que** ladite seconde extrémité de ladite piste conductrice est reliée électriquement à l'unité électronique par un fil électrique (30) muni d'une gaine isolante (36) et traversant ladite au moins une spire, les première et seconde parties d'extrémité (32,34) de ce fil électrique étant au moins partiellement dénudées pour assurer les contacts électriques nécessaires à la liaison électrique entre ladite deuxième extrémité de ladite piste conductrice et l'unité électronique.

2. Carte selon la revendication 1, **caractérisée en ce que** lesdites première et seconde parties d'extrémité dudit fil électrique présentent respectivement des première et seconde zones aplaties et dénudées (32,34) définissant deux zones de contact électrique dudit fil électrique.

3. Carte selon la revendication 2, **caractérisée en ce qu'**un tronçon de piste conductrice supplémentaire (22; 22A), définissant des première et seconde plages de contact (23,24; 23A,24A), est agencé sur ce support isolant du côté de ladite unité électronique relativement à ladite au moins une spire, la première plage de contact étant reliée électriquement à ladite unité électronique et ladite première zone aplatie et dénudée (32) étant superposée à ladite seconde plage de contact et reliée électriquement à cette seconde plage, ladite seconde zone aplatie et dénudée (34) étant superposée à ladite seconde extrémité de ladite piste conductrice et reliée électriquement à cette seconde extrémité.

4. Carte selon la revendication 3, **caractérisée en ce que** le contact électrique entre la première partie d'extrémité du fil électrique et ladite seconde plage de contact ainsi que le contact électrique entre la seconde partie d'extrémité du fil électrique et ladite seconde extrémité de ladite piste conductrice sont réalisés sans soudure, un matériau d'enrobage (4,40) assurant l'application des première et seconde zones aplaties et dénudées respectivement contre la seconde plage de contact et contre la seconde extrémité de ladite piste conductrice.

5. Carte selon l'une quelconque des revendications précédentes, **caractérisée en ce que** ledit fil électrique (30) a un diamètre compris entre 50 et 150 microns.
